# EUROPÄISCHE PATENTSCHRIFT

(11) **EP 2 250 676 B1**
(45) Veröffentlichungstag und Bekanntmachung des Hinweises auf die Patenterteilung: **21.09.2011**
(21) Anmeldenummer: 09701376.7
(22) Anmeldetag: 07.01.2009
(51) Int. Cl.: H01L 31/18

(54) **Verfahren zur Herstellung eines photoaktiven Schichtenverbunds**
Method for producing a photoactive layered composite
Procédé de fabrication d'une structure composite photoactive

(30) Priorität: 09.01.2008 DE 102008004340
(43) Veröffentlichungstag der Anmeldung: 17.11.2010
(73) Patentinhaber: Helmholtz-Zentrum Berlin für Materialien und Energie GmbH, 14109 Berlin (DE)
(72) Erfinder: AGGOUR, Mohammed, MA-14000 Kenitra (MA); LEWERENZ, Hans-Joachim, 10629 Berlin (DE); SKORUPSKA, Katarzyna, PL-60-546 Poznan (PL)
(86) Internationale Anmeldenummer: PCT/DE2009/000013
(87) Internationale Veröffentlichungsnummer: WO 2009/086820

(56) Entgegenhaltungen:
- DE-A1- 10 347 401
- M. AGGOUR ET AL: ""Photoactive Silicon-Based Nanostructure by Self-Organized Electrochemical Processing"" JOURNAL OF THE ELECTROCHEMICAL SOCIETY, Bd. 154, Nr. 9, 23. Juli 2007 (2007-07-23) , Seiten H794-H797, XP002579997 Pennington, New Jersey, USA in der Anmeldung erwähnt
- LEWERENZ ET AL: "Anodic oxides on silicon" ELECTROCHIMICA ACTA, ELSEVIER SCIENCE PUBLISHERS, BARKING, GB LNKD- DOI:10.1016/0013-4686(92)85037-L, Bd. 37, Nr. 5, 1. April 1992 (1992-04-01), Seiten 847-864, XP026512037 ISSN: 0013-4686 [gefunden am 1992-04-01]
- RAPPICH J ET AL: "In situ FTIR investigation of the electrochemical microstructuring of n-Si(111)" ELECTROCHIMICA ACTA, ELSEVIER SCIENCE PUBLISHERS, BARKING, GB LNKD- DOI:10.1016/0013-4686(95)00355-X, Bd. 41, Nr. 5, 1. April 1996 (1996-04-01), Seiten 675-680, XP004019528 ISSN: 0013-4686

## Beschreibung

Die Erfindung bezieht sich auf ein Verfahren zur Herstellung eines photoaktiven Schichtenverbunds mit einem Makroabsorber in Form eines dotierten Silizium-Substrats und einer Vielzahl von gleichrichtenden Nanoemittern in Form von mit einem Auskleidungsmetall versehenen Nanoporen, die sich zumindest in einer transparenten und elektrisch isolierenden Oxidschicht auf dem Makroabsorber befinden.

Bei der photovoltaischen Strom- oder Brennstofferzeugung ist die Effizienz der Umsetzung von Sonneneinstrahlung in elektrischen Strom oder Brennstoff von ausschlaggebender Bedeutung. Um eine optimale Ausbeute zu erhalten, werden neben einer Verringerung der Reflexions- und Rekombinationsverluste insbesondere eine Verringerung der Abschattungsverluste und eine Verbesserung der Lichtsammlung angestrebt. Abschattungen der Lichteinstrahlfläche treten insbesondere durch die Frontkontakte, durch die transparente, elektrisch leitende Leitschicht, beispielsweise ITO, und durch die Emitterschicht bei photovoltaischen Bauelementen in Form von Solarzellen vom Schottkytyp mit einem Festkörperkontakt zwischen der dotierten Halbleiterschicht und einer gleichrichtenden Metallschicht auf. Für eine effiziente photovoltaische Energieumwandlung zwischen Festkörperkontakten wird die Emitterschicht in der Regel als geschlossene Schicht, aber in sehr geringer Schichtstärke auf die als Basis bzw. Absorber arbeitende Halbleiterschicht aufgebracht.

### STAND DER TECHNIK

In der DE 103 47 401 A1 wird ein photoaktiver Schichtenverbund beschrieben, bei dem metallische Nanoemitter als Metallauskleidungen in einer nanostrukturierten Oxidschicht auf der lichtzugewandten Seite eines lichtabsorbierenden Makroabsorbers angeordnet sind. Die Nanoemitter vermeiden aufgrund ihrer Abmessungen im Nanometer-Bereich eine effizienzmindernde Abschattung der darunter liegenden absorbierende Halbleiterschicht. Den Emittern im photovoltaischen Bauelement kommt die Aufgabe zu, die durch Photoneneinfall in der Halbleiterschicht erzeugten Minoritätsladungsträger im Bereich des Festkörperkontakts zwischen dem Metall und der absorbierenden Halbleiterschicht zu sammeln und abzuleiten, sodass sie über eine Leitschicht und zugeordnete Kontakte abgeführt werden können. Der Festkörperkontakt Metall-Halbleiter bildet eine Schottky-Barriere, der keine Dotierung der Emitterschicht erfordert. Damit entfällt bei der Herstellung des photoaktiven Schichtenverbunds der zweite, sehr aufwändige Dotierungsschritt (der erste betrifft die Dotierung der Halbleiterschicht), der als Hochtemperaturprozess hochdotiert und auch noch hochgenau positioniert sein muss, aber trotzdem nur relativ unscharf ablaufen kann. Metallische Emitter mit Nanoabmessungen (bevorzugt zwischen 10 nm und 100 nm) waren bis dahin aus dem Stand der Technik nicht bekannt. Die erforderliche Nanostrukturierung wird bevorzugt durch mechanische Indentation der Oxidschicht erzeugt, wobei jede Öffnung einzeln erzeugt wird. Der Grad der Effizienz hängt damit von der Dichte und der Tiefe der einzeln eingebrachten Indentationen ab. Eine Nanostrukturierung durch chemisches Ätzen ist zwar auch möglich, dabei ist der Erzeugungsprozess jedoch nicht ausreichend kontrollierbar.

Aus der **VERÖFFENTLICHUNG I** "Study of surface morphology of electrochemically etched n-Si electrodes at different anodic potentials" von J. Jakubowicz (Cryst. Res. Technol. 38, No. 3-5, 313-319 (2003)) ist bekannt, dass Veränderungen der Oberflächenmorphologie bei n-Silizium nach einer Anodisation bei verschiedenen Spannungszuständen in einer Ammoniumfluorid-Lösung auftreten. Bei höherer Spannung tritt eine Formierung von Siliziumoxid auf. Bei 6 V können fortgesetzt Stromoszillationen an der Si-Elektrode in der wässrigen NH₄F-Lösung festgestellt werden. Diese werden der zyklischen Bildung und Auflösung von Siliziumoxid zugesprochen. Dabei ändert sich die Oberfläche zwischen glatt und rau in Abhängigkeit von den auftretenden Strompeaks.

Die selbstorganisierte Nanoporenformation in Siliziumoxid unter Photostromoszillationsbedingungen wird zunächst in der **VERÖFFENTUCHUNG II** "Self-organized nanostructures on silicon for photovoltaic applications" von H.J Lewerenz et al. (HMI Annual report 2005, pp 90-91) und chronologisch nachfolgend in dem **ABSTRACT I** "Nanotopography on self-organized structure formation on silicon" von K. Skorupska et al. (ECS Meeting - 2006, Denver, USA 07-12 May 2006), in dem **ABSTRACT II** "Photoactive Metal-Silicon Nanocomposite by Electrochemical Self Organization" von K. Skorupska et al. (Abstract 0088 ECS 210, Nov. 2006), in der **VERÖFFENTLICHUNG III** "Etectrochemically Induced Self-organized Nanostructures on Silicon for Realization of a Novel Nanoemitter Solar Cell Concept" von K. Skorupska et al. (ECS Trans 2, 1 2007) und der **VERÖFFENTLICHUNG IV** "Photoactive Silicon-Based Nanostructure by Self-Organized Electrochemical Processing" von M. Aggour et al. (J. of ECS, 154 (9) H794-H797, 2007) beschrieben.

Die zuletzt genannten Veröffentlichungen, insbesondere die **VERÖFFENTLICHUNG IV**, bilden den nächstliegenden Stand der Technik für die Erfindung. Aus allen ist ein Verfahren zur Herstellung eines photoaktiven Schichtenverbunds mit einem Makroabsorber und einer Vielzahl von Nanoemittern in Form von mit einem Auskleidungsmetall versehenen Nanoporen, die sich zumindest in einer transparenten und elektrisch isolierenden Oxidschicht auf dem Makroabsorber befinden, bekannt. Dabei ist das Verfahren dreistufig und besteht aus einem ersten elektrochemischen Tauchprozess eines Silizium-Substrats zur Erzeugung einer selbstorganisierten Nanoporenformation in einer Oxidschicht, einem zweiten elektrochemischen Tauchprozess zur Vertiefung der selbstorganisierten Nanoporenformation in das Silizium-Substrat und einem dritten elektrochemischen Tauchprozess zur Abscheidung eines Metalls in die vertiefte Nanostrukturierung. Aus den genannten Veröffentlichungen ist jedoch ausschließlich eine Erzeugung der selbstorganisierten Nanoporenformation in einem Fluorid-haltigen Elektrolyten bekannt, die auf dem Effekt der (Photo-)Stromoszillation in einer anodisch aufgewachsenen Oxidschicht beruht. Bei der (Photo-) Stromoszillation an Silizium-Elektroden in einem Ammoniumfluorid-haltigen Elektrolyten bei ungefähr +6V anodischem Potenzial wird ein Oxid gebildet, dessen Dicke integral (also über die Gesamtfläche der Elektrode) je nach Phase der zeitlichen Oszillation periodisch schwankt. Trotz einer mittleren Oxiddichte von ungefähr 8 nm bis 10 nm fließt ein Photostrom. Es konnte gezeigt werden, dass der Strom dadurch zustande kommt, dass das Oxid Nanoporen bis auf die Halbleiterschicht hinunter aufweist, die mit Elektrolyt gefüllt sind. Dadurch ergibt sich ein elektrisch leitfähiger Kontakt zwischen dem Elektrolyten und dem Silizium-Substrat und es fließt unter angelegter Spannung ein Strom. Die Anzahl und die Durchmesser der einzelnen Öffnungen in der Oxidschicht ändern sich mit der jeweiligen Phase des fließenden Stroms (das Oxid "atmet") und können somit genau eingestellt werden.

Die Nutzung einer selbstorganisiert aufgewachsenen Porosität in einer Oxidschicht stellte ein neues Konzept zur Erzeugung von Nanoemittern mit kleinsten Abmessungen dar. Durch die selbstorganisierte Nanostrukturierung entfällt eine Platzierung einzelner Nanostrukturelemente, beispielsweise durch Indentation, vollständig. Dabei kann trotzdem die mittlere Dichte der Nanostrukturierung gewählt und gezielt eingestellt werden, die sich bevorzugt aus der Anzahl, der Positionierung und den Durchmessern von einzelnen Poren in der porösen Oxidschicht ergibt. Dadurch wird eine unterschiedliche Flächendeckung (Bereiche mit beispielsweise vielen Poren, Bereiche mit weniger oder gar keinen Poren, große Porendurchmesser, kleine Porendurchmesser, mittlerer Porendurchmesser im Bereich von kleiner 50 nm) erreicht. Insbesondere kann die gewählte Flächendeckung einfach an die Qualität des verwendeten Halbleitermaterials angepasst werden. Trotz dieses bereits sehr ausgereiften, gut kontrollierbaren selbstorganisierten Niedertemperaturprozesses, durch dessen Einsatz ein großflächige, skalierbare und kostengünstige Erzeugung von Strom oder Brennstoffen ( insbesondere H₂, O₂, Methanol) möglich ist, konnten aber bei auf dem photoaktiven Schichtenverbund basierenden Solarzellen nur effektive Wirkungsgrade von unter 7% festgestellt werden.

### AUFGABENSTELLUNG

Die **AUFGABE** für die vorliegende Erfindung ist daher darin zu sehen, ein Verfahren zur Herstellung eines photoaktiven Schichtenverbunds mit einem Makroabsorber in Form eines Silizium-Substrats und einer Vielzahl von Nanoemittern in Form von mit einem Auskleidungsmetall versehenen Nanoporen, die sich zumindest in einer transparenten und elektrisch isolierenden Oxidschicht auf dem Makroabsorber befinden, der eingangs beschriebenen Art anzugeben, mit dem ein photoaktiver Schichtenverbund herstellbar ist, der Wirkungsgrade bei der Energieumwandlung mit zwei Festkörperkontakten von deutlich mehr als 7% möglich macht. Dabei sollen die beschriebenen Vorteile des gattungsgemäßen Verfahrens, insbesondere die ausschließliche kostengünstige Niedertemperaturführung sowie die Herstellbarkeit von großflächigen, skalierbaren Schichtenverbunden erhalten bleiben. Die **LÖSUNG** für diese Aufgabe ist dem Verfahrensanspruch zu entnehmen. Vorteilhafte Modifikationen werden in den jeweiligen Unteransprüchen aufgezeigt.

Das erfindungsgemäße Verfahren gliedert sich wiederum in drei, auch großflächig anwendbare nasschemische Verfahrensabschnitte, die kostengünstig niedertemperiert durchgeführt werden. Die einzelnen Verfahrensschritte in den Verfahrensabschnitten unterscheiden sich jedoch relevant von den bekannten Verfahrensschritten. Im Einzelnen werden bei dem erfindungsgemäßen Verfahren die nachfolgend aufgeführten Verfahrensschritte durchlaufen, wobei alle genannten Potenziale gegenüber einer gesättigten Kalomel-Elektrode angelegt werden:

Der erste Verfahrensabschnitt dient der Erzeugung der Nanoporen. In diesem Verfahrensabschnitt werden in einem selbstorganisierten Strukturierungsprozess die Nanoporen in einer ebenfalls in diesem Verfahrensschritt auf dem Silizium-Substrat aufwachsenden Oxidschicht erzeugt, die später die Nanoemitter aufnehmen. Dazu wird ein unbehandeltes Silizium-Substrat - welches später im Schichtenverbund den Makroabsorber bildet - in ein erstes Tauchbad mit einer Phthalat-haltigen Elektrolytlösung bei einem kathodischen Ruhepotenzial eingetaucht. Dabei ist die Anwesenheit von Phthalat im Elektrolyten von ausschlaggebender Bedeutung. Nach dem Eintauchen des unbehandelten dotierten Silizium-Substrats in die Phthalat-haltige Elektrolytlösung bei einem vorgegebenen kathodischen Ruhepotenzial wird das Potenzial erhöht bis auf ein vorgegebenes anodisches Potenzial, bei dem sich unter konstanter Belichtung ein konstanter Photostrom einstellt. Dabei kann das einzustellende anodische Potenzial aus einem Vorversuch mit identischen Parametern, insbesondere Silizium-Substrat, bekannt sein. Es kann aber auch eine Photostrom-Spannungscharakteristik während der Potenzialerhöhung bei konstanter Lichteinstrahlung aufgenommen werden, dann ist eine Vorauskenntnis der Verfahrensparameter nicht erforderlich. Tritt der aufgenommene Graph in eine horizontale Phase, ist das geeignete Gebiet des anodischen Potenzials erreicht und es wächst eine elektrisch isolierende Oxidschicht mit einer selbstorganisierten Verteilung von Nanoporen darin auf dem Silizium-Substrat auf. In diesem Bereich eines konstanten Photostroms wird dann das vorbehandelte Silizium-Substrat aus dem ersten Tauchbad entnommen. Dabei bestimmt der Entnahmezeitpunkt die Dicke des aufgewachsenen Oxids, welches bei dem erfindungsgemäßen verfahren ultradünn sein kann in eine Bereich von nur 1 nm, und die Dichte und Größe der darin entstandenen Nanoporen.

Befinden sich die erzeugten Nanoporen nur in der Oxidschicht, sodass die Festkörperkontakte an der Grenzfläche zwischen der Oxidschicht und dem Silizium-Substrat entstehen, bedingt dies eine elektronisch sehr hochwertige Ausführung des Silizium-Substrats, damit die in der Halbleiterschicht durch Photoneneinfall erzeugten Minoritätsladungsträger durch die gesamte Halbleiterschicht ohne Rekombination hindurchwandern und die Festkörperköntakte erreichen können. Bei elektronisch geringerwertigem und damit bedeutsam kostengünstigerem Halbleitermaterial sind jedoch die mittleren Diffusionslängen der Ladungsträger sehr viel geringer und es kommt zu Rekombinationen in der Halbleiterschicht, bevor die Festkörperkontakte erreicht werden. Deshalb ist eine Erstreckung der Nanoporen bis in das Halbleiter-Substrat sehr vorteilhaft. Dadurch kann auch elektronisch schlechteres Material mit kleinen Diffusionslängen, beispielsweise poly- bzw. mikrokristallines Silizium, eingesetzt werden, was die Herstellungskosten der photoaktiven Verbundschicht erheblich senkt.

Deshalb dient der zweite Verfahrensabschnitt der Vertiefung der Nanoporen in der Oxidschicht in das darunter liegende Silizium-Substrat. Dafür wird das vorbehandelte Silizium-Substrat in ein zweites Tauchbad mit einer alkalischen Elektrolytlösung eingetaucht. Während des Eintauchens wird eine erste chronoamperometrische Messung zur Bestimmung des optimalen Entnahmezeitpunkts durchgeführt. Bei der chronoamperometrischen Messung wird ein chronoamperometrisches Profil vom Verlauf des Elektrolysestroms am Silizium-Substrat als Arbeitselektrode über die Zeit bei einem konstanten angelegten Potenzial aufgenommen. Da diese Messung ohne Beleuchtung erfolgt, entspricht der sich einstellende Elektrolysestrom dem Dunkelstrom des Verbundschichtsystems. Stellt sich ein abnehmender Dunkelstrom bei einem konstanten kathodischen Potenzial ein, ist der optimale Zeitbereich für eine Entnahme des zwischenbehandelten Silizium-Substrats gekommen. Dabei bestimmt der genaue Entnahmezeitpunkt im optimalen Zeitintervall die Tiefe der Nanoporen im Silizium-Substrat.

Der dritte Verfahrensabschnitt dient der Metallauskleidung der vertieften Nanoporen mit einem zur Dotierung des verwendeten Silizium-Substrat gleichrichtenden Metall, das eine Schottky-Barriere zum Halbleitermaterial aufbaut, zur Erzeugung der Nanoemitter. Dazu wird das zwischenbehandelte Silizium-Substrat in ein drittes Tauchbad mit einem das Ion des Auskleidungsmetalls enthaltenden Redox-Elektrolyten eingetaucht. Auch bei diesem Tauchvorgang wird synchron eine zweite chronoamperometrische Messung durchgeführt. Das endbehandelte Silizium-Substrat wird dann in dem Zeitbereich aus dem dritten Tauchbad entnommen, in dem sich ein abnehmender Dunkelstrom bei einem konstanten kathodischen Potenzial zeigt. Dabei bestimmt der genaue Entnahmezeitpunkt im optimalen Zeitintervall die Dicke der Metallauskleidungen und die inselförmige Ausbreitung von Metallablagerungen auf der Oxidschicht um die Nanoporen herum. Mit dem dritten Verfahrensschritt ist der Schichtenverbund fertigprozessiert und kann beispielsweise zur einer Solarzelle weiterverarbeitet werden. Bevorzugt kann auch zuvor noch ein Temperschritt zum Abbau von inneren Spannungen und zur Verbesserung der Oxidmorphologie (bessere Isolatoreigenschaften) und der elektronischen Grenzflächeneigenschaften im Schichtenverbund durchgeführt werden. Weitere Einzelheiten zu dem Verfahren nach der Erfindung sind dem speziellen Beschreibungsteil zu entnehmen.

Im ersten Verfahrensabschnitt zur Erzeugung einer Oxidschicht auf dem Silizium-Substrat mit einer selbstorganisierten Nanoporenverteilung ist die Verwendung einer Phthalat-haltigen Elektrolytlösung im Tauchbad essenziell. Als Phthalate werden die Salze und Ester der Phthalsäuren (meist o-Phthalsäure = 1,2-Benzoldicarbonsäure) mit verschiedenen Alkoholen bezeichnet. Der überwiegende Teil der industriell in großen Mengen erzeugten Phthalate wird als Weichmacher für Kunststoffe wie PVC, Nitrocellulose oder synthetisches Gummi verwendet. Die wichtigsten Vertreter der Phthalate sind Dioctylphthalat (DOP, Veresterungsprodukt aus o-Phthalsäure mit 2-Ethylhexanol, Alternativbezeichnung: Diehtylhexylphthalat, DEHP) und Diisononylphthalat (DINP). Dimethyl-, Diethyl- oder Dibutylphthalat kommen auch als Bestandteil von Kosmetik oder Körperpflegemitteln und pharmazeutischen Produkten zum Einsatz. Weiterhin wird Kaliumhydrogenphthalat zur Herstellung von Pufferlösungen, als Titersubstanz für Alkalilaugen in der Maßanalyse und als Einkristall in der Röntgenspektrometrie verwendet. Bevorzugt wird bei der Erfindung eine Kaliumhydrogenphthalat-haltige Elektrolytlösung als Pufferlösung im ersten Tauchbad verwendet. Kaliumhydrogenphthalat (Synonyme Kaliumbiphthalat, Phthalsäure Monokaliumsalz) hat die Summenformel C₈H₅KO₄ und ist beispielsweise bei der Fa. Merck Art. 104874 kommerziell erhältlich. Bei einer Verwendung von Kaliumhydrogenphthalat im ersten Tauchbad haben sich für ein n-leitendes Silizium-Substrat ein kathodisches Potenzial von -0,7 V beim Eintauchen des unbehandelten dotierten Silizium-Substrats in das erste Tauchbad und/oder ein anodisches Potenzial im Bereich von 0 bis 1 V beim Herausnehmen des vorbehandelten Silizium-Substrats aus dem ersten Tauchbad als optimale Verfahrensparameter herausgestellt. Die Verwendung anderer Hydrogenphthatate, insbesondere in Verbindung mit anderen Alkalimetallen (erste Hauptgruppe, basische Reaktion, Lithium, Natrium, Rubidium, Cäsium) ist ebenfalls möglich. Phthalate sind dem Fachmann aus dem Stand der Technik in großer Anzahl bekannt.

Für das zweite Tauchbad im zweiten Verfahrensabschnitt wird eine alkalische Elektrolytlösung eingesetzt. Alkalische Lösungen oder auch so genannte Laugen sind im engsten Sinne wässrige Lösungen von Alkalihydroxiden, wie zum Beispiel von Natriumhydroxid (Natronlauge) oder Kaliumhydroxid (Kalilauge). Eine weitere alkalische Lösung ist beispielsweise auch Kalkwasser. Im weiteren Sinne wird der Begriff auch für jede Lösung von Basen verwendet. Alkalische Lösungen im weitesten Sinne können auch nichtwässrige Lösungen sein. Wässrige Lösungen sind alkalisch, wenn die Konzentration der Hydroxid-lonen OH⁻ die der Oxonium -Ionen H₃O⁺ übersteigt. Der pH-Wert ist dann größer als 7. Stark alkalische wässrige Lösungen haben einen pH-Wert größer als 10, zum Beispiel hat eine normale Natronlauge einen pH-Wert von 14. Alkalische Elektrolytlösungen sind einfach synthetisierbar und dem Fachmann aus dem Stand der Technik in großer Anzahl bekannt. Bei dem Verfahren nach der Erfindung wird eine Kali- oder Natronlauge-haltige Elektrolytlösung bevorzugt. Kalilauge ist der Trivialname für eine stark alkalische, ätzende, wässrige Lösung von Kaliumhydroxid. Mit Kalilauge lässt sich im Labor Kohlendioxid aus Gasgemischen entfernen, da es mit dem gelösten Kaliumhydroxid zu Kaliumcarbonat reagiert. Große Mengen Kalilauge werden in der chemischen Industrie zur Herstellung von Seifen und Farbstoffen verbraucht. Wie andere Laugen auch, neutralisiert Kalilauge Säuren aller Art, wobei jeweils Kaliumsalze entstehen. Beispielsweise reagiert Kaliumhydroxid (KOH) mit Salzsäure (HCl aq) zu Wasser und Kaliumchlorid. Natronlauge ist die Bezeichnung für Lösungen von Natriumhydroxid (NaOH) in Wasser. Bei diesen Lösungen handelt es sich um alkalische Lösungen. Das Natriumhydroxid löst sich unter starker Wärmebildung sehr gut in Wasser. Eine bei Raumtemperatur gesättigte wässrige Lösung enthält pro Liter 1260 g Natriumhydroxid. Natronlauge ist eine der am häufigsten verwendeten Labor- und Industriechemikalien. Bei der Verwendung derartiger Laugen haben sich ein kathodisches Potenzial von -0,8 V beim Eintauchen des vorbehandelten Silizium-Substrats in das zweite Tauchbad und/oder ein Entnehmen des zwischenbehandelten Silizium-Substrats aus dem zweiten Tauchbad nach 900 s als optimale Verfahrensparameter herausgestellt.

Für das dritte Tauchbad im dritten Verfahrensabschnitt wird eine Hexachloroplatinsäure-haltige Elektrolytlösung bevorzugt, sodass es zu einer Platinabscheidung in den Nanoporen kommt. Hexachloridoplatinsäure (Summenformel H₂PtCl₆) entsteht bei der oxidativen Auflösung von Platin in Königswasser. Aus wässriger Lösung entsteht dabei das Hexachloridoplatinsäure-Hexahydrat H₂PtCl₆ x 6 H₂O, welches sich bis zum Dihydrat entwässern lässt. Darüber hinaus erfolgt ein Zerfall in Wasser, Salzsäure und Platintetrachlorid, da die Protonen der Oxonium-Ionen nach dem Entzug des Wassers keine geeignete Koordinationsstelle am PtCl₆-Ion finden. Bei der Verwendung einer Hexachloroplatinsäure-haltigen Elektrolytlösung (und einer gleichzeitigen Anwesenheit von K₂SO₄ - Kaliumsulfat) hat sich bevorzugt ein kathodisches Potenzial von -4,0 V beim Eintauchen des zwischenbehandelten Silizium-Substrats in das dritte Tauchbad über einen Zeitraum von 10 s (Singlepuls) herausgestellt. Das Entnehmen des endbehandelten Silizium-Substrats hängt von dem gewünschten Metallverbrauch (Nanoinseldichte und -größe) ab und kann beispielsweise schon nach 10 s oder auch erst nach 60 s erfolgen.

Alternativ kann die Abscheidung auch bei anderen Potenzialen erfolgen, beispielsweise -0,8 V oder -0, 4 V. Damit sind Möglichkeiten gegeben, den Abscheidungsprozess auf die Größenverteilung der Nanoporen abzustimmen, da bei anderen Potenzialen ein anderer Nukleationsprozess der Pt-Teilchen stattfindet. Eine weitere Möglichkeit zur Beeinflussung des Elektrodepositionsvorgangs liegt in der Entnahmezeit. Damit kann prinzipiell die insgesamt abgeschiedene Menge von Pt und damit die Größe und Anzahl der Nanoinseln bestimmt werden. Zudem kann durch einen Potenzialsprung von offener Zellspannung zu dem gewünschten Abscheidepotenzial und einer anschließenden Einstellung der Abscheidezeit der Wachstumsmodus und damit Größe und Form der Metallinseln in den Nanoporen beeinflusst werden.

Zusammenfassend gesehen handelt es sich bei dem beanspruchten Verfahren nach der Erfindung um ein sehr effizientes Verfahren, mit dem im Niedertemperaturbereich großflächig photoaktive Schichtenverbunde einfach, gut kontrollierbar und kostengünstig hergestellt werden können. Im speziellen Beschreibungsteil wird an einem Ausführungsbeispiel aufgezeigt, dass mit dem nach der Erfindung hergestellten Schichtenverbund Wirkungsgrade bei der Energieumwandlung von über 10% sofort erzeugbar waren. Dabei können auch elektronisch minderwertigere Absorbermaterialien eingesetzt werden, auch in Silizium-Dünnschichtsystem mit mikrokristallinem Silizium oder einem anderen rekristallisierten Material. Weiterhin wird ein kompletter Dotierungsschritt eingespart. Alle Prozessschritte sind sehr moderat und umweltverträglich, die zur Herstellung erforderlichen Tauchbadsubstanzen verbrauchen sich nur wenig oder sind recyclebar. Gleiches gilt für einen photoaktiven Schichtenverbund mit einem Makroabsorber in Form eines Silizium-Substrats und einer Vielzahl von Nanoemittern in Form von mit einem Auskleidungsmetall versehenen Nanoporen, die sich zumindest in einer transparenten und elektrisch isolierenden Oxidschicht auf dem Makroabsorber befinden, der durch das zuvor genannte Verfahren herstellbar ist. Ein solcher Schichtenverbund kann bevorzugt aus einem n-leitend dotierten Silizium-Substrat bestehen. Die Oxidschicht kann bevorzugt eine mittlere Dicke im Bereich ab 1 nm aufweisen. Als Auskleidungsmetalle zum Aufbau von zur Dotierung des Silizium-Substrats gleichrichtenden Schottky-Barrieren können Platin, Iridium, Rhodium oder Ruthenium verwendet werden.

Die Hauptanwendungen des photoaktiven Schichtenverbunds nach der Erfindung sind in der lichtinduzierten Erzeugung von Strom und Brennstoff zu finden. Zunächst wurde eine entsprechende Ausgestaltung als photovoltaische Solarzelle vorgenommen. Dabei kann es sich insbesondere auch um Dünnschichtsolarzellen oder um photoelektrochemische Solarzellen mit einer lodlodid-haltigen Redox-Elektrolytlösung handeln. Bei einer Anwendung als Festkörpersolarzelle wirkt es sich weiter effizienzsteigernd aus, wenn vorgesehen ist, dass auf das Silizium-Substrat rückseitig vor einem Rückkontakt eine Verspiegelungsschicht aufgebracht ist, die dorthin migrierte Minoritätsladungsträger in Richtung der Festkörperkontakte reflektiert. Als weitere effizienzsteigernde Modifikationen kann noch vorgesehen sein, dass alle Nanoemitter von einer transparenten Leitschicht in Form einer ZnO- oder SnO₂-Schicht kontaktiert werden und dass auch auf die transparente Leitschicht eine Antireflexionsschicht aufgebracht ist. Zunehmend werden photovoltaische Bauelemente aber auch zur direkten Erzeugung von Brennstoff oder zur Sauerstoffreduktion oder ähnlichen Vorgängen eingesetzt. Der grundlegende Aufbau des photoaktiven Schichtenverbunds nach der Erfindung verändert sich dadurch nicht, auch können die oben erwähnten Weiterbildungen ausgeführt werden. Findet jedoch eine Verwendung insbesondere als brennstoffwandelndes (H₂) oder sauerstoffreduzierendes (O₂) Photovoltaiksystem statt, ist es besonders vorteilhaft, wenn das Schottky-Barrieren ausbildende Auskleidungsmetall auch katalytische Eigenschaften aufweist und beispielsweise chemische Spaltvorgänge zur Brennstofferzeugung beschleunigt. Hierbei kann es sich dann beispielsweise wieder um Pt, Ir, Rh oder Ru handeln. Von Vorteil ist hierbei insbesondere, dass nur eine äußerst geringe Metallmenge in der angenähert homogen verteilten Nanostrukturierung zur Erzielung einer hohen katalytischen Aktivität eingesetzt werden muss, wodurch sich eine erhebliche Umweltentlastung ergibt.

### AUSFÜHRUNGSBEISPIELE

Ausbildungsformen des Verfahrens zur Herstellung eines photoaktiven Schichtenverbunds nach der Erfindung dafür werden nachfolgend zum weiteren Verständnis der Erfindung anhand der schematischen Figuren näher erläutert. Dabei zeigt:
- **FIGUR 1**: ein Diagramm für den ersten Verfahrensabschnitt,
- **FIGUR 2A**: eine elektronenmikroskopische Aufnahme einer erzeugten Nanoporenstruktur in der Draufsicht,
- **FIGUR 2B**: eine elektronenmikroskopische Aufnahme einer metallausge- kleideten Nanoporenstruktur gemäß Figur 2A in der Draufsicht,
- **FIGUR 3**: ein chronoamperometrisches Profil für den zweiten Verfahrens- abschnitt,
- **FIGUR 4**: eine Schematik zur erforderlichen Porenvertiefung im zweiten Verfahrensabschnitt (Stand der Technik),
- **FIGUR 5**: ein chronoamperometrisches Profil für den dritten Verfahrens- abschnitt (Depositionsprotokoll),
- **FIGUR 6**: ein Leistungsdiagramm des photoaktiven Schichtenverbunds in der Anwendung einer elektrochemischen Solarzelle.

Bei dem Verfahren nach der Erfindung handelt es sich um ein dreistufiges Konditionierungsverfahren unter Verwendung selbstorganisierter Niedertemperaturprozesse, das Wirkungsgrade von deutlich über 10%.

### 1. VERFAHRENSABSCHNITT: ERZEUGUNG VON NANOPOREN

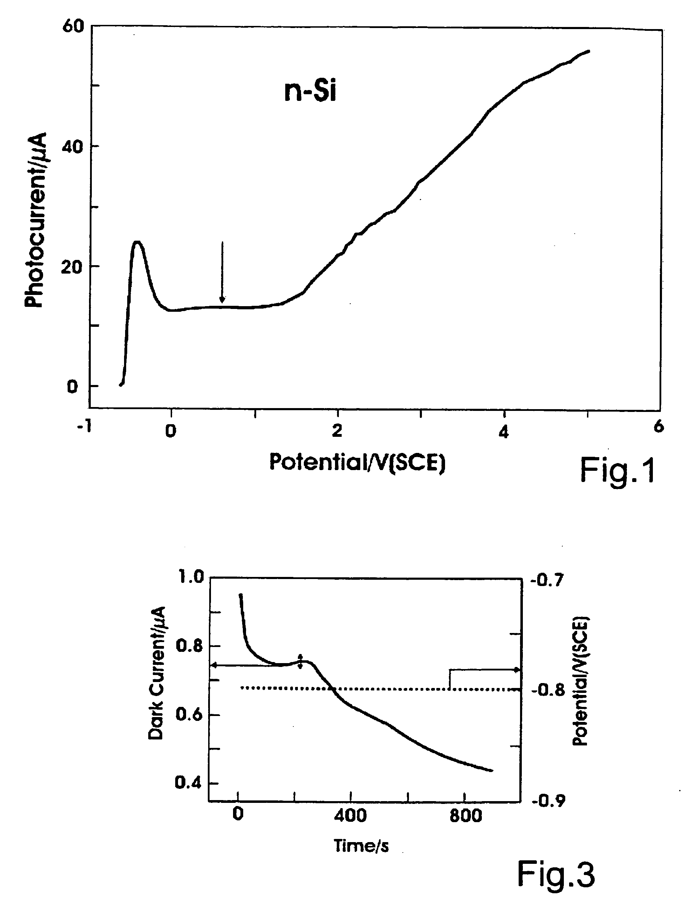

Zur Erzeugung von Nanoporen in einer elektrisch isolierenden, passivierenden Oxidschicht wird ein n-leitendes Silizium-Substrat (als Arbeitselektrode) in eine Phthalat-haltige Elektrolytlösung getaucht. Die **FIGUR 1** zeigt die zugehörige Photostrom-Spannungschrakteristik (Photostrom/Photocurrent in µA über dem Potenzial in V vs. SCE) einer n-leitenden Silizium-Elektrode (n-Si) mit den Parametern 0,1 M Kaliumhydrogenphthalat-Lösung bei pH 4, Potenzial- Vorschubgeschwindigkeit 0,1 Vs⁻¹, Lichtintensität 23 mWcm⁻²; Belichtung durch Wolfram-Jod Lampe. Deutlich ist zu erkennen, dass keine Oszillation auftritt. Eine derartige Charakteristik kann einmalig zur Ermittlung des erforderlichen Potenzialwerts an einer entsprechenden Silizium-Probe durchgeführt werden. Bei analogen Silizium-Substraten ist dann nur noch die Einstellung des entsprechenden ermittelten Potenzials erforderlich. Alternativ kann aber auch die Photostromcharakteristik bei der Durchführung des ersten Verfahrensabschnitts mitgefahren werden, wobei eine entsprechende Beleuchtung erforderlich ist. Das Silizium-Substrat wird in die Phthalat-haltige Elektrolytlösung bei einem Ruhepotenzial von -0,7 V vs. der gesättigten Kalomel-Elektrode (SCE) eingetaucht, zu einem Potenzial im Bereich des horizontalen Plateaus gefahren und beispielsweise bei demjenigen Potenzial aus der Elektrolytlösung entnommen, das durch den Pfeil in **FIGUR 1** gekennzeichnet ist. Auf dem unbehandelten dotierten Silizium-Substrat ist eine Oxidschicht äußerst geringer Dicke (im Bereich von 1 nm) mit selbstorganisiert verteilten Nanoporen entstanden.

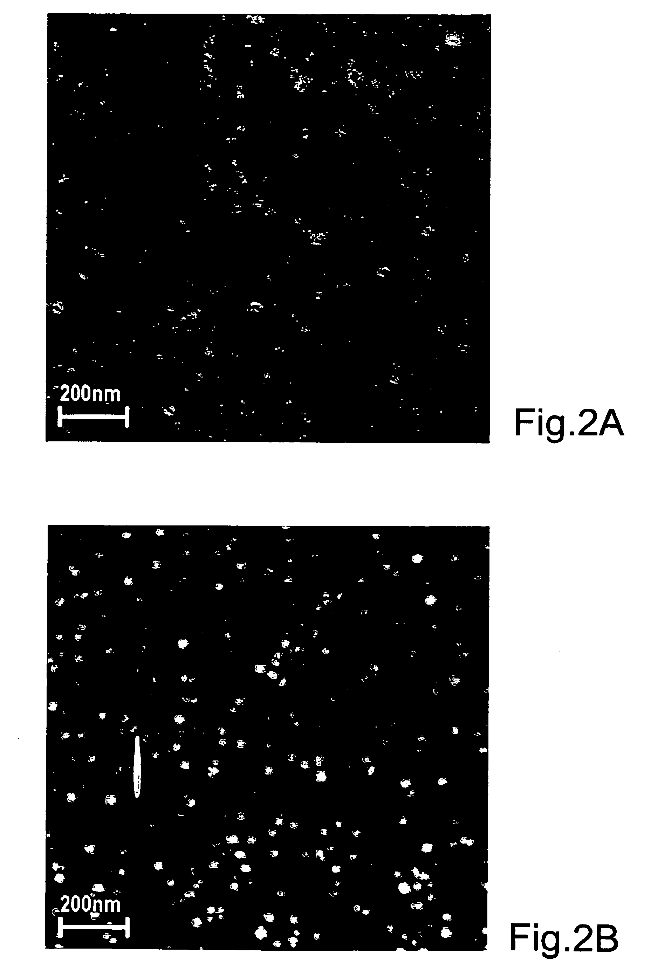

Die **FIGUR 2A** zeigt eine hochaufgelöste Aufnahme mit einem Elektronenrastermikroskop eines erzeugten Nanoporenfelds. Die Nanoporen haben einen Durchmesser in einem Bereich von 20 nm. Zu erkennen ist auch die hohe Porendichte. Die **FIGUR 2B** zeigt das Nanoporenfeld gemäß **FIGUR 2A** nach der Elektrodeposition von Platin als Auskleidungsmetall. Zu erkennen ist die weitgehend gleichmäßige Verteilung der verfüllten Nanoporen, wobei nicht alle erzeugten Nanoporen auch verfüllt worden. Die Elektrodeposition ist in Dichte und Inselgröße steuerbar (siehe 3. Verfahrensabschnitt).

### 2. VERFAHRENSABSCHNITT: VERTIEFUNG DER NANOPOREN

Anschließend wird das vorbehandelte Silizium-Substrat in eine alkalische Elektrolytlösung getaucht, um auszunutzen, dass Silizium in alkalischen Lösungen selektiv geätzt wird, während das auf der Oberfläche des Siliziums im ersten Verfahrensabschnitt gebildete Oxid weitgehend unbeeinträchtigt bleibt. Der Ätzprozess erzeugt ein Wachstum der Nanoporen in das vorbehandelte Silizium-Substrat hinein. Während des Tauchvorganges wird ein erstes chronoamperometrisches Profil erstellt, vergleiche **FIGUR 3** (chronoamperometrisches Profil für n-Si in 2M NaOH, pH 14, eingetaucht bei einem Potenzial von -0.8V vs. SCE, Dunkelstrom/Dark Current in µA über der Zeit/Time in s und Potenzial/Potential in V vs. SCE). Das chronoamperometrische Profil gibt Aufschluss über die zu erwartende Effizienz eines auf dem photoaktiven Schichtenverbund aufgebauten photovoltaischen Bauelements. Das zwischenbehandelte Silizium-Substrat wird bei einem kathodischen Potenzial von -0,8V eingetaucht und der zeitliche Verlauf (Chronoamperometrie) des sich einstellenden Dunkelstromes verfolgt. In dem Gebiet um den Graphen herum bildet sich eine Akkumulationsschicht mit einer vermehrten effektiven Ladungsträgeransammlung (n₀>10¹⁸cm⁻³). Die Bildung einer solchen Akkumulationsschicht ist im 2. Verfahrensabschnitt anzustreben. Der Dunkelstromverlauf stellt ein somit ein Selektionskriterium für effiziente photovoltaische Bauelemente dar. Wenn der Dunkelstrom nahezu konstant bleibt oder zunimmt, ergeben sich geringere Wirkungsgrade bei der Energieumwandlung. Wenn der Dunkelstrom abnimmt, ergeben sich höhere Wirkungsgrade. Im gezeigten Ausführungsbeispiel erfolgt eine Probenentnahme nach 900 s.

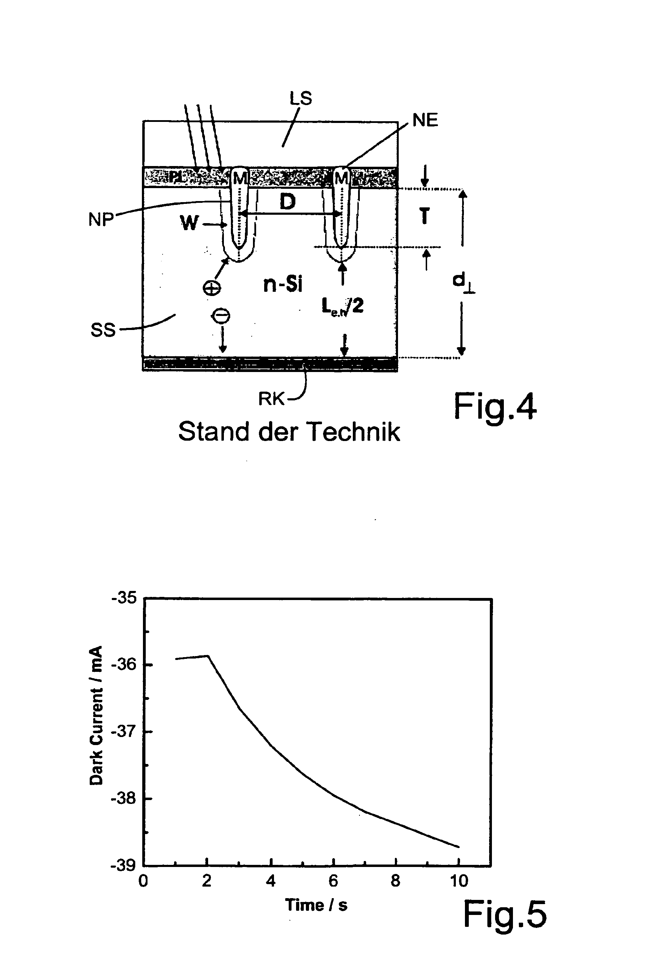

Die **FIGUR 4** zeigt an einer Festkörper-Solarzelle eine Schematik zur Veranschaulichung des Erfordernisses der Vertiefung von Nanoporen durch die elektrochemische Konditionierung im zweiten Verfahrensabschnitt in einer alkalischen Elektrolytlösung. Gezeigt ist ein endbehandeltes Silizium-Substrat SS (n-leitend, Makroabsorber der Dicke d⊥, L_{e,h}: Minoritätsladungsträgerdiffusionslänge L (Index e für Elektronen, p-leitendes Si; Index h für Löcher, n-Si). ) mit einem Rückkontakt RK, einer Oxidschicht PL (passivierende Schicht, hier Siliziumoxid, Dicke beispielsweise 8-10 nm) und einem transparenten Leitschicht LS, die von einem nicht weiter dargestellten Frontkontakt kontaktiert wird. Der Lichteinfall ist durch schräge Pfeile angedeutet. Eine Vielzahl von Nanoemittern NE (mit einem Metall M verfüllte Nanoporen NP in der Oxidschicht PL und dem Silizium-Substrat SS) weisen einen lateralen Abstand D, eine Halbleiterrandschicht W (Akkumulationsschicht) und eine Tiefe T im Silizium-Substrat SS auf. Bei der gezeigten Tiefe T der Nanoemitter ist eine optimale Ableitung aller Ladungsträger gewährleistet und eine übermäßige Rekombination - auch bei einem elektronisch schlechteren Siliziummaterial mit einer kürzeren Diffusionslänge - sicher verhindert.

### 3. VERFAHRENSABSCHNITT: METALLAUSKLEIDUNG DER NANOPOREN

In diesem Verfahrensabschnitt werden Metallbeläge mittels Elektrodeposition in und um die Nanoporen abgeschieden. Dazu wird das zwischenbehandelte Silizium-Substrat in ein drittes Tauchbad mit einem Ionen des Auskleidungsmetalls enthaltenden Redox-Elektrolyten eingetaucht. Auch hier folgt auf die Wahl des Abscheidepotenzials ein chronoamperometrischer Konditionierungsschritt. In der **FIGUR 5** ist ein entsprechendes chronoamperometrisches Profil bzw. Depositionsprotokoll (Dunkelstrom/ Dark Current in mA über der Zeit/Time in s von kristallinem n-Si (Orientierung (100) mit einem spezifischen Widerstand von 0,3-1,5 Ωcm in 1 mM H₂PtCl₆ und 0,1 M K₂SO₄, Kaliumsulfat) dargestellt. Es wurde ein konstantes kathodisches Potenzial von -4 V vs. SCE als Einzelpuls an das zwischenbehandelte Silizium-Substrat für 10 s angelegt. Im Bereich des abnehmenden Dunkelstroms wurde das Silizium-Substrat dem Tauchbad entnommen. Es sind Platin-Nanoinseln in den Nanoporen entstanden. Dabei bestimmt der Entnahmezeitpunkt die Dichte und Größe der Nanoinseln. Die Entnahme muss zwar im Gebiet abnehmenden Dunkelstroms liegen, der Entnahmezeitpunkt kann aber beispielsweise schon bei 10 s oder erst bei 60 s liegen. Der genaue Entnahmezeitpunkt hängt von den Anforderungen an die zu erzeugenden photoaktive Schichtenverbund ab.

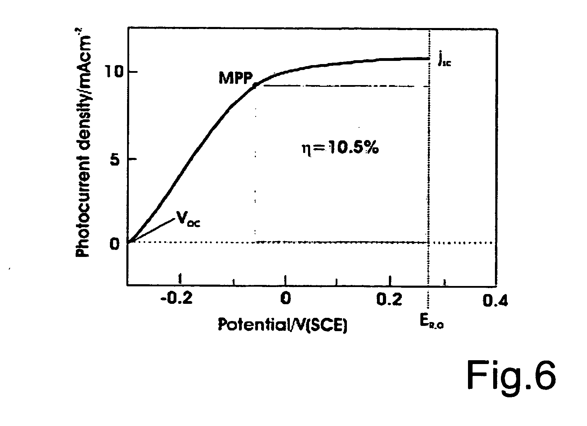

Als photovoltaisches Bauelement, das auf dem photoaktiven Schichtenverbund nach der Erfindung basiert, wurde eine stromerzeugende photoelektrochemische Solarzelle präpariert. Der Redox-Elektrolyt war eine lod/lodid- Lösung, bestehend aus 50 mM J₂ und 1 M KJ. Nach der vorstehend beschriebenen Präparation ergab sich ein Wirkungsgrad für die Energieumwandlung von 10,5%, vergleiche **FIGUR 6** (Photostromdichte/Photocurrent densitiy in mAcm⁻² über dem Potenzial/Potential in V vs. SCE (Redoxpotenzial der Iod-Iodid-Elektrolyt-Lösung) mit MPP: Arbeitspunkt; V_{oc}: Leerlaufspannung; j_{sc}: Kurzschlussstrom; E_{R,O}:).

Eine Veröffentlichung, die sich auch auf die beanspruchte Erfindung bezieht, ist in Vorbereitung (H.-J. Lewerenz: "Metal Electrodeposition onto (photo)electrochemically Prepared Nanostructured Silicon Surfaces: Solar Applications" in Transactions of the Institute of Metal Finishing (IMF), Hothersall Memorial Article, Vol. 86, No. 1, erscheint voraussichtlich 20. Januar 2008).

## Patentansprüche

1. Verfahren zur Herstellung eines photoaktiven Schichtenverbunds mit einem Makroabsorber in Form eines dotierten Silizium-Substrats und einer Vielzahl von gleichrichtenden Nanoemittern in Form von mit einem Auskleidungsmetall versehenen Nanoporen, die sich zumindest in einer transparenten und elektrisch isolierenden Oxidschicht auf dem Makroabsorber befinden, mit den Verfahrensschritten, wobei alle auftretenden Potenziale gegenüber einer gesättigten Kalomel-Elektrode angelegt werden :
I) Erzeugung von Nanoporen
• Eintauchen eines unbehandelten dotierten Silizium-Substrats in ein erstes Tauchbad mit einer Phthalat-haltigen Elektrolytlösung bei einem kathodischen Potenzial und Erhöhen des Potenzials bis auf ein vorgegebenes anodisches Potenzial, bei dem sich unter konstanter Belichtung ein konstanter Photostrom einstellt, und Entnehmen des vorbehandelten Silizium-Substrats im Bereich des konstanten Photostroms,
II) Vertiefung der Nanoporen
• Eintauchen des vorbehandelten Silizium-Substrats in ein zweites Tauchbad mit einer alkalischen Elektrolytlösung unter Durchführen einer ersten chronoamperometrischen Messung und Entnehmen des zwischenbehandelten Silizium-Substrats zu einem Zeitpunkt bei einem abnehmenden Dunkelstrom bei einem konstanten kathodischen Potenzial und
III) Metallauskleidung der Nanoporen
• Eintauchen des zwischenbehandelten Silizium-Substrats in ein drittes Tauchbad mit einem das Ion des Auskleidungsmetalls enthaltenden Redox-Elektrolyten unter Durchführen einer zweiten chronoamperometrischen Messung und Entnehmen des endbehandelten Silizium-Substrats zu einem Zeitpunkt bei einem abnehmenden Dunkelstrom bei einem konstanten kathodischen Potenzial.

2. Verfahren nach Anspruch 1,
**GEKENNZEICHNET DURCH**
eine Kaliumhydrogenphthalat-haltige Elektrolytlösung im ersten Tauchbad.

3. Verfahren nach Anspruch 2,
**GEKENNZEICHNET DURCH**
ein kathodisches Potenzial von -0,7 V beim Eintauchen des unbehandelten dotierten Silizium-Substrats in das erste Tauchbad und/oder ein anodisches Potenzial im Bereich von 0 bis 1 V beim Herausnehmen des vorbehandelten Silizium-Substrats aus dem ersten Tauchbad.

4. Verfahren nach Anspruch 1,
**GEKENNZEICHNET DURCH**
eine Kali- oder Natronlauge-haltige Elektrolytlösung im zweiten Tauchbad.

5. Verfahren nach Anspruch 4,
**GEKENNZEICHNET DURCH**
ein kathodisches Potenzial von -0,8 V beim Eintauchen des vorbehandelten Silizium-Substrats in das zweite Tauchbad und/oder
ein Entnehmen des zwischenbehandelten Silizium-Substrats aus dem zweiten Tauchbad nach 900 s.

6. Verfahren nach Anspruch 1,
**GEKENNZEICHNET DURCH**
eine Hexachloroplatinsäure-haltige Elektrolytlösung im dritten Tauchbad.

7. Verfahren nach Anspruch 6,
**GEKENNZEICHNET DURCH**
ein kathodisches Potenzial von -4,0 V beim Eintauchen des zwischenbehandelten Silizium-Substrats in das dritte Tauchbad über einen Zeitraum von 10 s.

8. Verfahren nach Anspruch 1,
**GEKENNZEICHNET DURCH**
Tempern des vorbehandelten Silizium-Substrats.

## Claims

1. A method for producing a photoactive laminar composite comprising a macorabsorber in the form of a doped silicon substrate and a plurality of rectifying nanoemitters in the form of nanopores which are provided with a lining metal and are arranged on the macroabsorber at least in a transparent and electrically insulating oxide layer, said method comprising the following method steps wherein all potentials which occur are applied to a saturated calomel electrode:
I) generation of nanopores
• dipping an untreated doped silicon substrate into a first dipping bath with a phthalate-containing electrolyte solution at a cathodic potential and increasing the potential until at a predetermined anodic potential, at which a constant photocurrent is set with constant illumination, and removing the pre-treated silicon substrate in the range of the constant photocurrent,
II) impressing the nanopores
• dipping the pre-treated silicon substrate into a second dipping bath with an alkaline electrolyte solution whilst carrying out a first chronoamperometric measurement and removing the silicon substrate, which has been treated in the meantime, at a moment of decreasing dark current at a constant cathodic potential, and
III) metal-coating the nanopores
• dipping the silicon substrate, which has been treated in the meantime, into a third dipping bath with a redox electrolyte containing the ion of the lining metal whilst carrying out a second chronoamperometric measurement, and removing the finished silicon substrate at a moment of decreasing dark current at a constant cathodic potential.

2. The method according to claim 1, **characterised by** a potassium-hydrogen-phthalate-containing electrolyte solution in the first dipping bath.

3. The method according to claim 2, **characterised by** a cathodic potential of -0.7 V when dipping the untreated doped silicon substrate into the first dipping bath and/or an anodic potential in the range of 0 to 1 V when removing the pre-treated silicon substrate from the first dipping bath.

4. The method according to claim 1, **characterised by** a caustic-potash-solution-containing or sodium-hydroxide-solution-containing electrolyte solution in the second dipping bath.

5. The method according to claim 4, **characterised by** a cathodic potential of -0.8 V when dipping the pre-treated silicon substrate in the second dipping bath and/or removing the silicon substrate, which has been treated in the meantime, from the second dipping bath after 900 s.

6. The method according to claim 1, **characterised by** a hexachloroplatinic-acid-containing electrolyte solution in the third dipping bath.

7. The method according to claim 6, **characterised by** a cathodic potential of -0.4 V when dipping the silicon substrate, which has been treated in the meantime, into the third dipping bath over a period of 10 s.

8. The method according to claim 1, **characterised by** tempering the pre-treated silicon substrate.

## Revendications

1. Procédé de fabrication d'un stratifié composite photo-actif ayant un macro-absorbeur sous forme d'un substrat en silicium dopé et une pluralité de nano-émetteurs à effet redresseur sous forme de nano-pores pourvus d'un métal de revêtement situés au moins dans une couche d'oxyde transparente et électriquement isolatrice en-dessus dudit macro-absorbeur, avec les étapes de procédé suivantes, l'ensemble des potentiels mentionnés se rapportant à une électrode au calomel saturée :
I) génération de nano-pores
• immersion d'un substrat non-traité en silicium dopé dans un premier bain d'immersion renfermant une solution électrolytique contenant des phtalates, le potentiel cathodique étant d'abord cathodique pour ensuite être augmenté jusqu'à ce qu'il atteigne une valeur anodique prédéfinie à laquelle circulera, lors d'une exposition à une lumière constante, un courant photoélectrique constant, puis retrait du substrat prétraité en silicium en maintenant des conditions de circulation dudit courant photoélectrique,
II) approfondissement des nano-pores
• immersion dudit substrat prétraité en silicium dans un deuxième bain d'immersion renfermant une solution électrolytique alcaline en réalisant une première mesure chronoampérométrique, puis retrait du substrat en silicium ayant subi un traitement intermédiaire quand le courant d'obscurité diminue alors qu'un potentiel cathodique constant se maintient et
III) revêtement au métal des nano-pores
• immersion dudit substrat en silicium ayant subi un traitement intermédiaire dans un troisième bain d'immersion renfermant un électrolyte d'oxydoréduction contenant l'ion du métal de revêtement en réalisant une deuxième mesure chronoampérométrique, puis retrait du substrat en silicium ayant subi son traitement définitif quand le courant d'obscurité diminue alors qu'un potentiel cathodique constant se maintient.

2. Procédé selon la revendication 1, **CARACTÉRISÉ PAR** une solution électrolytique contenant du biphtalate de potassium, dans le premier bain d'immersion.

3. Procédé selon la revendication 2, **CARACTÉRISÉ PAR** un potentiel cathodique de -0,7 V lors de l'immersion dudit substrat non-traité en silicium dopé dans le premier bain d'immersion et/ou un potentiel anodique comprise entre 0 et 1 V lors du retrait dudit substrat prétraité en silicium du premier bain d'immersion.

4. Procédé selon la revendication 1, **CARACTÉRISÉ PAR** une solution électrolytique contenant de l'hydroxyde de potassium ou de sodium, dans le deuxième bain d'immersion.

5. Procédé selon la revendication 4, **CARACTÉRISÉ PAR** un potentiel cathodique de -0,8 V lors de l'immersion dudit substrat prétraité en silicium dans le deuxième bain d'immersion et/ou un retrait dudit substrat en silicium ayant subi un traitement intermédiaire, au terme de 900 s, du deuxième bain d'immersion.

6. Procédé selon la revendication 1, **CARACTÉRISÉ PAR** une solution électrolytique contenant de l'acide hexachloroplatinique, dans le troisième bain d'immersion.

7. Procédé selon la revendication 6, **CARACTÉRISÉ PAR** un potentiel cathodique de -4,0 V lors de l'immersion dudit substrat en silicium ayant subi un traitement intermédiaire, pour une durée de 10 s, dans le troisième bain d'immersion.

8. Procédé selon la revendication 1, **CARACTÉRISÉ PAR** un recuit dudit substrat prétraité en silicium.
